# EUROPEAN PATENT SPECIFICATION

(11) **EP 3 174 366 B1**
(45) Date of publication and mention of the grant of the patent: **13.03.2019**
(21) Application number: 15842313.7
(22) Date of filing: 08.09.2015
(51) Int. Cl.: H05K 1/18, G02B 6/26

(54) **BASEBAND PROCESSING UNIT**
BASISBANDVERARBEITUNGSEINHEIT
UNITÉ DE TRAITEMENT DE BANDE DE BASE

(30) Priority: 17.09.2014 CN 201420536195 U
(43) Date of publication of application: 31.05.2017
(73) Proprietor: Huawei Technologies Co., Ltd., Longgang District Shenzhen, Guangdong 518129 (CN)
(72) Inventor: LUO, Yijing, Shenzhen Guangdong 518129 (CN); ZHANG, Haoliang, Shenzhen Guangdong 518129 (CN); ZHANG, Ying, Shenzhen Guangdong 518129 (CN)
(74) Representative: Thun, Clemens
(86) International application number: PCT/CN2015/089186
(87) International publication number: WO 2016/041455

(56) References cited:
- CN-A- 101 149 448
- CN-A- 102 291 185
- CN-A- 102 883 355
- CN-U- 204 090 161
- US-A1- 2006 029 332
- US-A1- 2008 070 439
- US-A1- 2011 217 009
- US-A1- 2012 314 374
- US-A1- 2013 210 275

## Description

### TECHNICAL FIELD

This application relates to the field of communications technologies, and in particular, to a baseband processing unit.

### BACKGROUND

In the field of communications technologies, a BBU baseband processing unit includes a PCB circuit board, an optical port cage that is crimped on the PCB circuit board and used to plug-connect to an SFP optical module, and the SFP optical module plug-connected to the optical port cage.

For example, US 2006/0029332A1 refers to a rotate-and-pull mechanism for fiber optic modules. The mechanism has a lever-actuator to unlatch and withdraw a fiber optic module from a cage assembly or a module receptacle. The lever-actuator pivotally couples to the fiber optic module so that when lever-actuator is rotated about its pivot point, the lever-actuator causes a pivot-arm actuator to release the fiber optic module from the cage assembly. The pivot-arm actuator further including a keeper to engage into a latch in the cage assembly. A bracket, which may be coupled to the fiber optic module, provides a flexible arm portion to provide a counteracting force when the pivot-arm actuator rotates to release the fiber optic module from the cage assembly. The bracket may include a slot through which the keeper on the pivot-arm actuator may move through as the pivot-arm actuator pivots.

Further, US 2008/0070439 A1 refers to a connector mounting structure, a printed-wiring board having a cut portion, a modular connector connecting pattern provided adjacent to the cut portion, and a connecting pattern provided isolated from the modular connector connecting pattern and connecting an SFP connector. Also, the printed-wiring board and a front board are combined in order that the cut portion faces a plane of an opening which the front board has. When a modular connector is inserted into the opening, the modular connector is supported by the opening and the cut portion and concurrently the modular connector is electrically contacted with the modular connector connecting pattern. When an SFP front cage is inserted into the opening, the SFP front cage is supported by the opening and the cut portion and concurrently an SFP module becomes connectable to the SFP connector through the SFP front cage.

Further, US 2012/0314374A1 refers to an electronic system including a printed circuit board (PCB), and a heat dissipating element. The PCB includes one or more first electronic components mounted on a first side of the PCB, and one or more second electronic components mounted on a second side of the PCB. The first electronic components has a power consumption that is greater than a threshold and have a height over the first side of the PCB that is higher than any other electronic components mounted on the first side of the PCB. At least one of the second electronic components has a height over the second side of the PCB that is higher than the height of the first electronic components. The heat dissipating element is adjacent to the first electronic components so as to provide a thermal coupling for dissipating heat generated by the first electronic components.

Further, US 2011/0217009A1 refers to a system for connecting optical modules in an optical network comprising a printed circuit board, two cages, and two connectors. The printed circuit board may house electronic circuitry and a plurality of electronic components. The printed circuit board may have a component side and a solder side. The two cages may be mounted back-to-back on opposite sides of the printed circuit board, each cage having a connector end and an I/O end. The two connectors may be mounted back-to-back on opposite sides of the printed circuit board. Each of the two cages may be configured to guide an optical module into the respective connector. Each of the two cages may be mounted at an angle from the respective surface of the printed circuit board such that the respective I/O ends of the two cages are farther apart than the respective connector ends of the two cages.

When a design manner in which optical port cages are crimped on both sides of a circuit board is used for a baseband processing unit, two optical port cages are disposed on the circuit board included in the baseband processing unit, the two optical port cages are arranged in a thickness direction of the circuit board, and the circuit board is located between the two optical port cages. Each optical port cage is disposed on the edge of the circuit board, and a plug-connection interface that is of each optical port cage and used to plug-connect to an optical module is located on a side that is of the optical port cage and that is perpendicular to the circuit board. A pin of each optical port cage is plug-connected to a crimping hole of the circuit board in a crimping manner, one optical module is plug-connected to each optical port cage, and two optical modules are arranged in the thickness direction of the circuit board.
In the baseband processing unit in the prior art, because of a specific board thickness of the circuit board, a spacing between the two optical modules is quite small, and disassembly/assembly operation space of the two optical modules is relatively small. When insertion and extraction are being performed between one optical module and an optical port cage, a risk of mutual interference exists between the optical module and the other optical module.

### SUMMARY

This application provides a baseband processing unit. When a design manner in which optical port cages are crimped on both sides of a circuit board is used for the baseband processing unit, disassembly/assembly operation space of two optical modules is relatively large, so as to help disassembly/assembly of the two optical modules.
In a first aspect a baseband processing unit is provided comprising:
- a circuit board extending in a plane having a top surface, an opposite bottom surface, and four side surfaces connecting the top and bottom surface,
- a first optical port cage, a second optical port cage, a first optical module, and a second optical module; wherein the first optical port cage and the second optical port cage are arranged in a thickness direction, being a direction perpendicular to the plane, of the circuit board, and both, the first optical port cage and the second optical port cage, are
provided with multiple pins, the second optical port cage is installed on the bottom surface of circuit board, the first optical module is plug-connected to the first optical port cage, the second optical module is plug-connected to the second optical port cage, and an extraction lever of the first optical module and an extraction lever of the second optical module are located on a same side of one of the side surfaces of the circuit board; wherein a first base plate is disposed on the top surface of the circuit board, the first base plate is fastened on the circuit board, the first base plate is provided with a crimping hole whose opening is located on a surface of the first base plate, which faces away from the circuit board, and a pin of the first optical port cage is plug-connected to the crimping hole of the first base plate.

In a first implementation form of the first aspect the first base plate is fastened on the circuit board specifically comprises:
the first base plate has a circuit board structure, and the first base plate is welded to the circuit board.

In a second implementation form of the first aspect the first base plate is welded to the circuit board specifically comprises:
a first pad is disposed on the top surface of the circuit board that faces the first base plate, a second pad is disposed on a surface of the first base plate that faces the circuit board, and the circuit board is welded to the first base plate by using the first pad and the second pad.

In a third implementation form of the first aspect the circuit board has a crimping hole whose opening is located on the bottom surface of the circuit board, and a pin of the second optical port cage is plug-connected to the crimping hole of the circuit board.

In a fourth implementation form of the first aspect a thickness of the first base plate is greater than or equal to a length of the pin of the first optical port cage; and a thickness of the circuit board is greater than or equal to a length of the pin of the second optical port cage.

In a fifth implementation form of the first aspect a side of the top surface of the circuit board is a solder side of the circuit board, and a side of the bottom surface of the circuit board is a plug-connection side of the circuit board.

In a sixth implementation form of the first aspect a side of the first base plate, which faces the circuit board, is a solder side of the first base plate, and a side of the first base plate facing away from the circuit board is a plug-connection side of the first base plate.

In a seventh implementation form of the first aspect the first base plate is fastened on the circuit board specifically comprises:
the first base plate is stuck to the circuit board.

In an eighth implementation form of the first aspect the second optical port cage is installed on the circuit board specifically comprises:
a second base plate is disposed on the bottom side of the circuit board, the second base plate is fastened on the circuit board, the second base plate has a crimping hole whose opening is located on a surface of the second base plate, which faces away from the circuit board, and the pin of the second optical port cage is plug-connected to the crimping hole of the second base plate.

In a ninth implementation form of the first aspect the second base plate is fastened on the circuit board specifically comprises:
the second base plate is welded to the circuit board; or
the second base plate is stuck to the circuit board.

In the baseband processing unit provided in the foregoing first aspect, a first base plate is disposed on a side that is of a circuit board and that is away from a second optical port cage, a pin of a first optical port cage is plug-connected to a crimping hole of the first base plate, a first optical module is plug-connected to the first optical port cage, and a second optical module is plug-connected to the second optical port cage. Therefore, parts that are in the circuit board and on
which the first optical port cage and the second optical port cage are installed are locally thickened, so that when a thickness of the circuit board is specific, a spacing between the first optical module and the second optical module can be relatively large, and further, disassembly/assembly space of the first optical module and the second optical module is expanded, thereby helping disassembly/assembly of the first optical module and the second optical module.

### BRIEF DESCRIPTION OF DRAWINGS

To describe the technical solutions in the embodiments of this application more clearly, the following briefly describes the accompanying drawings required for the embodiments. Apparently, the accompanying drawings in the following description show merely some embodiments of this application, and a person of ordinary skill in the art may still derive other drawings from these accompanying drawings without creative efforts.
FIG. 1 is a schematic structural diagram of a baseband processing unit according to an embodiment of this application;
FIG. 2 is a schematic structural diagram of a side that is of a circuit board and that is away from a first base plate in a baseband processing unit according to an embodiment of this application;
FIG. 3 is a schematic structural diagram of a side that is of a circuit board and that faces a first base plate in a baseband processing unit according to an embodiment of this application;
FIG. 4 is a schematic structural diagram of a side that is of a first base plate and that faces a circuit board in a baseband processing unit according to an embodiment of this application; and
FIG. 5 is a schematic structural diagram of a side that is of a first base plate and that is away from a circuit board in a baseband processing unit according to an embodiment of this application.

### DESCRIPTION OF EMBODIMENTS

The following clearly and completely describes the technical solutions in the embodiments of this application with reference to the accompanying drawings in the embodiments of this application. Apparently, the described embodiments are merely some but not all of the embodiments of this application. All other embodiments obtained by a person of ordinary skill in the art based on the embodiments of this application without creative efforts shall fall within the protection scope of this application.

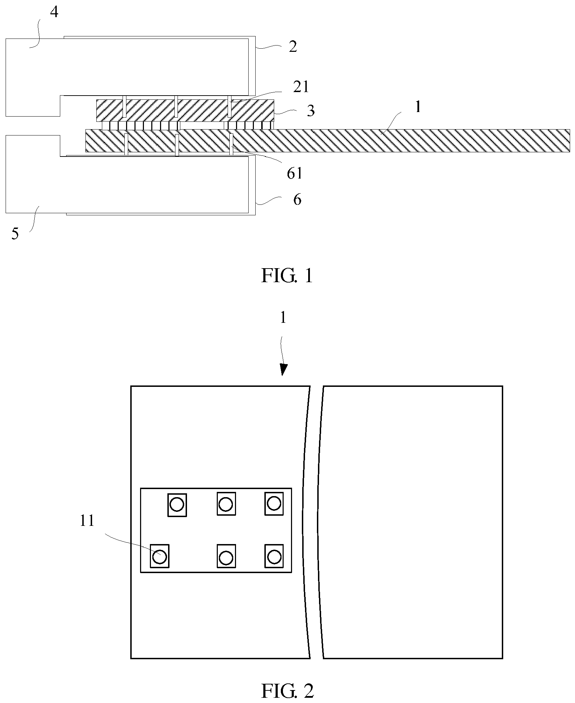

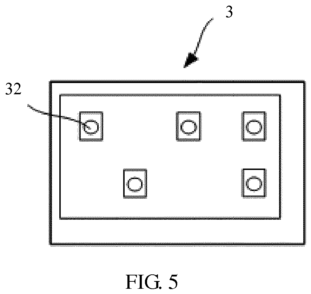

Referring to FIG. 1 and FIG. 5, FIG. 1 is a schematic structural diagram of a baseband processing unit according to an embodiment of this application, and FIG. 5 is a schematic structural diagram of a side that is of a first base plate and that is away from a circuit board in a baseband processing unit according to an embodiment of this application.

As shown in FIG. 1, the baseband processing unit provided in this embodiment includes a circuit board 1, a first optical port cage 2, a second optical port cage 6, a first optical module 4, and a second optical module 5. The first optical port cage 2 and the second optical port cage 6 are arranged in a thickness direction of the circuit board 1, the first optical port cage 2 is provided with multiple pins 21, the second optical port cage 6 is provided with multiple pins 61, and the second optical port cage 6 is installed on the circuit board 1. The first optical module 4 is plug-connected to the first optical port cage 2, the second optical module 5 is plug-connected to the second optical port cage 6, and an extraction lever of the first optical module 4 and an extraction lever of the second optical module 5 are located on a same side of the circuit board 1. Referring to orientation shown in FIG. 1, the extraction lever of the first optical module 4 and the extraction lever of the second optical module 5 are located on a left side of the circuit board 1. A first base plate 3 is disposed on a side that is of the circuit board 1 and that is away from the second optical port cage 6, and the first base plate 3 is fastened on the circuit board 1. As shown in FIG. 5, the first base plate 3 is provided with a crimping hole 32 whose opening is located on a surface of a side that is of the first base plate 3 and that is away from the circuit board 1, and the pin 21 of the first optical port cage 2 is plug-connected to the crimping hole 32 of the first base plate 3.

In the baseband processing unit, the first base plate 3 is disposed on the side that is of the circuit board 1 and that is away from the second optical port cage 6, the pin 21 of the first optical port cage 2 is plug-connected to the crimping hole 32 of the first base plate 3, the first optical module 4 is plug-connected to the first optical port cage 2, and the second optical module 5 is plug-connected to the second optical port cage 6. Therefore, parts that are in the circuit board 1 and on which the first optical port cage 2 and the second optical port cage 6 are installed are locally thickened, so that when a thickness of the circuit board 1 is specific, a spacing between the first optical module 4 and the second optical module 5 can be relatively large, and further, disassembly/assembly space of the first optical module 4 and the second optical module 5 is expanded, thereby helping disassembly/assembly of the first optical module 4 and the second optical module 5.

As shown in FIG. 1 and FIG. 2, in a preferred implementation manner, the circuit board 1 has a crimping hole 11 whose opening is located on a surface of a side that is of the circuit board 1 and that is away from the first base plate 3, and the pin 61 of the second optical port cage 6 is plug-connected to the crimping hole 11 of the circuit board 1.

Preferably, a thickness of the first base plate 3 is greater than or equal to a length of the pin 21 of the first optical port cage 2; and a thickness of the circuit board 1 is greater than or equal to a length of the pin 61 of the second optical port cage 6. In this case, the pin 21 of the first optical port cage 2 does not protrude from the first base plate 3. In addition, the pin 61 of the second optical port cage 6 does not protrude from the circuit board 1. Therefore, when the first optical port cage 2 and the second optical port cage 6 are being installed, no interference is generated between the pin 21 of the first optical port cage 2 and the pin 61 of the second optical port cage 6, and no avoidance location needs to be set.

Certainly, in the baseband processing unit, a second base plate may also be disposed on a side that is of the circuit board 1 and that is away from the first optical port cage 2, and the pin 61 of the second optical port cage 6 may be plug-connected to a crimping hole (which is not shown in the figure) included in the second base plate disposed on the side that is of the circuit board 1 and that is away from the first optical port cage 2. According to the baseband processing unit with the structure, operation space between the first optical module 4 and the second optical module 5 can be further expanded.

The second base plate and the circuit board 1 may be fastened in a welding manner, or certainly, may be fastened in a sticking manner. Details are not described herein.

Certainly, there are multiple manners of connecting the first base plate 3 and the circuit board 1.

In a preferred implementation manner, that the first base plate 3 disposed on the side that is of the circuit board 1 and that is away from the second optical port cage 6 is fastened on the circuit board 1 may specifically include:
the first base plate 3 has a circuit board structure, and the first base plate 3 is welded to the circuit board 1.

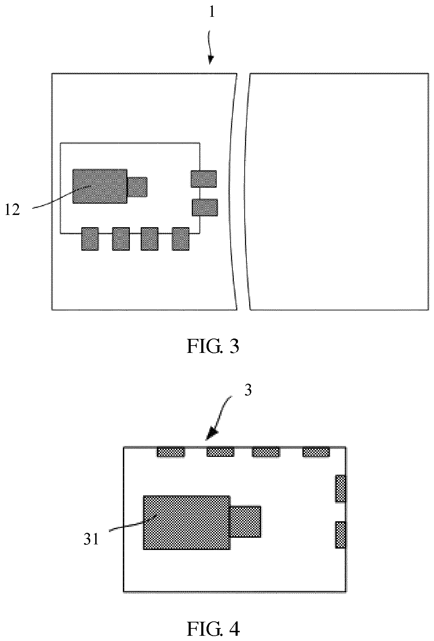

Specifically, as shown in FIG. 1, FIG. 3, and FIG. 4, a first pad 12 is disposed on a side that is of the circuit board 1 and that faces the first base plate 3, a second pad 31 is disposed on a side that is of the first base plate 3 and that faces the circuit board 1, and the circuit board 1 is welded to the first base plate 3 by using the first pad 12 and the second pad 31.

In a preferred implementation manner, a side that is of the circuit board 1 and that faces the first base plate 3 is a solder side of the circuit board 1, and a side that is of the circuit board 1 and that is away from the first base plate 3 is a plug-connection side of the circuit board 1.

In addition, when the first base plate 3 has the circuit board structure, a side that is of the first base plate 3 and that faces the circuit board 1 is a solder side of the first base plate 3, and a side that is of the first base plate 3 and that is away from the circuit board 1 is a plug-connection side of the first base plate 3.

Certainly, alternatively, the first base plate 3 may be stuck to the circuit board 1, so as to fixedly connect the first base plate 3 and the circuit board 1.

Apparently, a person skilled in the art can make various modifications and variations to the embodiments of this application without departing from the scope of this application. This application is intended to cover these modifications and variations of this application provided that they fall within the scope of protection defined by the following claims.

## Claims

1. A baseband processing unit comprising:
• a circuit board (1) extending in a plane and having a top surface, an opposite bottom surface and four side surfaces connecting the top and bottom surface,
• a first optical port cage (2), a second optical port cage (6), a first optical module (4), and a second optical module (5); wherein the first optical port cage (2) and the second optical port cage (6) are arranged in a thickness direction, being a direction perpendicular to the plane, of the circuit board (1), and both, the first optical port cage (2) and the second optical port cage (6), are provided with multiple pins (21), the second optical port cage (6) is installed on the bottom surface of circuit board (1), the first optical module (4) is plug-connected to the first optical port cage (2), the second optical module (5) is plug-connected to the second optical port cage (6), and an extraction lever of the first optical module (4) and an extraction lever of the second optical module (5) are located on a same side of one of the side surfaces of the circuit board (1); wherein a first base plate (3) is disposed on the top surface of the circuit board (1) , the first base plate (3) is fastened on the circuit board (1), the first base plate (3) is provided with a crimping hole (32) whose opening is located on a surface of the first base plate (3), which faces away from the circuit board (1), and a pin (21) of the first optical port cage (2) is plug-connected to the crimping hole (32) of the first base plate (3).

2. The baseband processing unit according to claim 1, wherein that the first base plate (3) is fastened on the circuit board (1) specifically comprises:
the first base plate (3) has a circuit board structure, and the first base plate (3) is welded to the circuit board (1).

3. The baseband processing unit according to claim 2, wherein that the first base plate (3) is welded to the circuit board (1) specifically comprises:
a first pad (12) is disposed on the top surface of the circuit board (1) that faces the first base plate (3), a second pad (31) is disposed on a surface of the first base plate (3) that faces the circuit board (1), and the circuit board (1) is welded to the first base plate (3) by using the first pad (12) and the second pad (31).

4. The baseband processing unit according to claim 1, wherein the circuit board (1) has a crimping hole (11) whose opening is located on the bottom surface of the circuit board (1), and a pin (61) of the second optical port cage (6) is plug-connected to the crimping hole (11) of the circuit board (1).

5. The baseband processing unit according to claim 4, wherein a thickness of the first base plate (3) is greater than or equal to a length of the pin (21) of the first optical port cage (2); and a thickness of the circuit board (1) is greater than or equal to a length of the pin (61) of the second optical port cage (6).

6. The baseband processing unit according to claim 2, wherein a side of the top surface of the circuit board (1) is a solder side of the circuit board (1), and a side of the bottom surface of the circuit board (1) is a plug-connection side of the circuit board (1).

7. The baseband processing unit according to claim 6, wherein a side of the first base plate (3), which faces the circuit board (1); is a solder side of the first base plate (3), and a side of the first base plate (3) facing away from the circuit board (1) is a plug-connection side of the first base plate (3).

8. The baseband processing unit according to claim 1, wherein that the first base plate (3) is fastened on the circuit board (1) specifically comprises:
the first base plate (3) is stuck to the circuit board (1).

9. The baseband processing unit according to any one of claims 1 to 8, wherein that the second optical port cage (6) is installed on the circuit board (1) specifically comprises:
a second base plate is disposed on the bottom side of the circuit board (1) , the second base plate is fastened on the circuit board (1), the second base plate has a crimping hole whose opening is located on a surface of the second base plate, which faces away from the circuit board (1), and the pin (61) of the second optical port cage (6) is plug-connected to the crimping hole of the second base plate.

10. The baseband processing unit according to claim 9, wherein that the second base plate is fastened on the circuit board (1) specifically comprises:
the second base plate is welded to the circuit board (1); or
the second base plate is stuck to the circuit board (1).

## Patentansprüche

1. Basisbandverarbeitungseinheit, umfassend:
- eine Leiterplatte (1), die sich in einer Ebene erstreckt und eine Oberseite, eine gegenüberliegende Unterseite und vier Seitenflächen aufweist, die die Ober- und Unterseite verbinden,
- einen ersten optischen Portkäfig (2), einen zweiten optischen Portkäfig (6), ein erstes optisches Modul (4) und ein zweites optisches Modul (5); wobei der erste optische Portkäfig (2) und der zweite optische Portkäfig (6) in einer Dickenrichtung, die eine Richtung senkrecht zur Ebene ist, der Leiterplatte (1) angeordnet sind, und sowohl der erste optische Portkäfig (2) als auch der zweite optische Portkäfig (6) mit mehreren Stiften (21) versehen sind, der zweite optische Portkäfig (6) auf der Unterseite der Leiterplatte (1) installiert ist, das erste optische Modul (4) mit dem ersten optischen Portkäfig (2) steckbar verbunden ist, das zweite optische Modul (5) mit dem zweiten optischen Portkäfig (6) steckbar verbunden ist und ein Extraktionshebel des ersten optischen Moduls (4) und ein Extraktionshebel des zweiten optischen Moduls (5) auf einer gleichen Seite einer der Seitenflächen der Leiterplatte (1) angeordnet sind; wobei eine erste Grundplatte (3) auf der Oberseite der Leiterplatte (1) angeordnet ist, die erste Grundplatte (3) auf der Leiterplatte (1) befestigt ist, die erste Grundplatte (3) mit einem Crimpanschlussloch (32) versehen ist, dessen Öffnung auf einer von der Leiterplatte (1) abgewandten Oberfläche der ersten Grundplatte (3) angeordnet ist, und ein Stift (21) des ersten optischen Portkäfigs (2) mit dem Crimpanschlussloch (32) der ersten Grundplatte (3) steckbar verbunden ist.

2. Basisbandverarbeitungseinheit nach Anspruch 1, wobei die erste Grundplatte (3) auf der Leiterplatte (1) befestigt ist und insbesondere umfasst:
die erste Grundplatte (3) weist eine Leiterplattenstruktur auf und die erste Grundplatte (3) ist mit der Leiterplatte (1) verschweißt.

3. Basisbandverarbeitungseinheit nach Anspruch 2, wobei die erste Grundplatte (3) mit der Leiterplatte (1) verschweißt ist und insbesondere umfasst:
eine erste Kontaktstelle (12) ist auf der Oberseite der Leiterplatte (1) angeordnet, die der ersten Grundplatte (3) zugewandt ist, eine zweite Kontaktstelle (31) ist auf einer Oberfläche der ersten Grundplatte (3) angeordnet, die der Leiterplatte (1) zugewandt ist, und die Leiterplatte (1) ist mit der ersten Grundplatte (3) unter Verwendung der ersten Kontaktstelle (12) und der zweiten Kontaktstelle (31) verschweißt.

4. Basisbandverarbeitungseinheit nach Anspruch 1, wobei die Leiterplatte (1) ein Crimpanschlussloch (11) aufweist, dessen Öffnung sich auf der Unterseite der Leiterplatte (1) befindet, und ein Stift (61) des zweiten optischen Portkäfigs (6) mit dem Crimpanschlussloch (11) der Leiterplatte (1) verbunden ist.

5. Basisbandverarbeitungseinheit nach Anspruch 4, wobei eine Dicke der ersten Grundplatte (3) größer oder gleich einer Länge des Stiftes (21) des ersten optischen Portkäfigs (2) ist; und eine Dicke der Leiterplatte (1) größer oder gleich einer Länge des Stiftes (61) des zweiten optischen Portkäfigs (6) ist.

6. Basisbandverarbeitungseinheit nach Anspruch 2, wobei eine Seite der Oberseite der Leiterplatte (1) eine Lötseite der Leiterplatte (1) ist und eine Seite der Unterseite der Leiterplatte (1) eine Steckverbindungsseite der Leiterplatte (1) ist.

7. Basisbandverarbeitungseinheit nach Anspruch 6, wobei eine Seite der ersten Grundplatte (3), die der Leiterplatte (1) zugewandt ist, eine Lötseite der ersten Grundplatte (3) ist, und eine Seite der ersten Grundplatte (3), die der Leiterplatte (1) abgewandt ist, eine Steckerverbindungsseite der ersten Grundplatte (3) ist.

8. Basisbandverarbeitungseinheit nach Anspruch 1, wobei die erste Grundplatte (3) auf der Leiterplatte (1) befestigt ist und insbesondere umfasst: die erste Grundplatte (3) wird auf die Leiterplatte (1) geklebt.

9. Basisbandverarbeitungseinheit nach einem der Ansprüche 1 bis 8, wobei der zweite optische Portkäfig (6) auf der Leiterplatte (1) installiert ist und insbesondere umfasst: eine zweite Grundplatte ist auf der Unterseite der Leiterplatte (1) angeordnet, die zweite Grundplatte ist auf der Leiterplatte (1) befestigt, die zweite Grundplatte weist ein Crimpanschlussloch auf, dessen Öffnung sich auf einer von der Leiterplatte (1) abgewandten Oberfläche der zweiten Grundplatte befindet, und der Stift (61) des zweiten optischen Portkäfigs (6) ist mit dem Crimpanschluss der zweiten Grundplatte steckbar verbunden.

10. Basisbandverarbeitungseinheit nach Anspruch 9, wobei die zweite Grundplatte auf der Leiterplatte (1) befestigt ist, die insbesondere umfasst: die zweite Grundplatte ist mit der Leiterplatte (1) verschweißt; oder
die zweite Grundplatte ist auf die Leiterplatte (1) geklebt.

## Revendications

1. Unité de traitement de bande de base comprenant :
• une carte de circuits imprimés (1) s'étendant dans un plan et possédant une surface supérieure, une surface inférieure opposée et quatre surfaces latérales connectant la surface supérieure et la surface inférieure,
• une première cage (2) de port optique, une seconde cage (6) de port optique, un premier module optique (4) et un second module optique (5) ; la première cage (2) de port optique et la seconde cage (6) de port optique étant conçues dans un sens de l'épaisseur, qui est un sens perpendiculaire au plan, de la carte de circuits imprimés (1), et à la fois, la première cage (2) de port optique et la seconde cage (6) de port optique étant dotées de multiples broches (21), la seconde cage (6) de port optique étant installée sur la surface inférieure de la carte de circuits imprimés (1), le premier module optique (4) étant connecté par fiche à la première cage (2) de port optique, le second module optique (5) étant connecté par fiche à la seconde cage (6) de port optique, et un levier d'extraction du premier module optique (4) et un levier d'extraction du second module optique (5) étant situés sur un même côté de l'une des surfaces latérales de la carte de circuits imprimés (1) ; une première plaque de base (3) étant disposée sur la surface supérieure de la carte de circuits imprimés (1), la première plaque de base (3) étant fixée sur la carte de circuits imprimés (1), la première plaque de base (3) étant dotée d'un trou de sertissage (32) dont l'ouverture est située sur une surface de la première plaque de base (3), qui tourne le dos à la carte de circuits imprimés (1), et une broche (21) de la première cage (2) de port optique étant connectée par fiche au trou de sertissage (32) de la première plaque de base (3).

2. Unité de traitement de bande de base selon la revendication 1, dans laquelle le fait que la première plaque de base (3) soit fixée sur la carte de circuits imprimés (1) comprend en particulier que :
la première plaque de base (3) possède une structure de carte de circuits imprimés, et
la première plaque de base (3) est soudée à la carte de circuits imprimés (1).

3. Unité de traitement de bande de base selon la revendication 2, dans laquelle le fait que la première plaque de base (3) soit soudée à la carte de circuits imprimés (1) comprend en particulier que :
une première pastille (12) est disposée sur la surface supérieure de la carte de circuits imprimés (1) qui fait face à la première plaque de base (3), une seconde pastille (31) est disposée sur une surface de la première plaque de base (3) qui fait face à la carte de circuits imprimés (1), et la carte de circuits imprimés (1) est soudée à la première plaque de base (3) à l'aide de la première pastille (12) et de la seconde pastille (31).

4. Unité de traitement de bande de base selon la revendication 1, dans laquelle la carte de circuits imprimés (1) possède un trou de sertissage (11) dont l'ouverture est située sur la surface inférieure de la carte de circuits imprimés (1), et une broche (61) de la seconde cage (6) de port optique est connectée par fiche au trou de sertissage (11) de la carte de circuits imprimés (1).

5. Unité de traitement de bande de base selon la revendication 4, dans laquelle une épaisseur de la première plaque de base (3) est supérieure ou égale à une longueur de la broche (21) de la première cage (2) de port optique ; et une épaisseur de la carte de circuits imprimés (1) est supérieure ou égale à une longueur de la broche (61) de la seconde cage (6) de port optique.

6. Unité de traitement de bande de base selon la revendication 2, dans laquelle un côté de la surface supérieure de la carte de circuits imprimés (1) est un côté de brasure de la carte de circuits imprimés (1), et un côté de la surface inférieure de la carte de circuits imprimés (1) est un côté de connexion par fiche de la carte de circuits imprimés (1).

7. Unité de traitement de bande de base selon la revendication 6, dans laquelle un côté de la première plaque de base (3), qui fait face à la carte de circuits imprimés (1), est un côté de brasure de la première plaque de base (3), et un côté de la première plaque de base (3) qui tourne le dos à la carte de circuits imprimés (1) est un côté de connexion par fiche de la première plaque de base (3).

8. Unité de traitement de bande de base selon la revendication 1, dans laquelle le fait que la première plaque de base (3) soit fixée sur la carte de circuits imprimés (1) comprend en particulier que :
la première plaque de base (3) est collée à la carte de circuits imprimés (1).

9. Unité de traitement de bande de base selon l'une quelconque des revendications 1 à 8, dans laquelle le fait que la seconde cage (6) de port optique soit installée sur la carte de circuits imprimés (1) comprend en particulier que :
une seconde plaque de base est disposée sur le côté inférieur de la carte de circuits imprimés (1), la seconde plaque de base est fixée sur la carte de circuits imprimés (1), la seconde plaque de base possède un trou de sertissage dont l'ouverture est située sur une surface de la seconde plaque de base, qui tourne le dos à la carte de circuits imprimés (1), et la broche (61) de la seconde cage (6) de port optique est connectée par fiche au trou de sertissage de la seconde plaque de base.

10. Unité de traitement de bande de base selon la revendication 9, dans laquelle le fait que la seconde plaque de base soit fixée sur la carte de circuits imprimés (1) comprend en particulier que :
la seconde plaque de base est soudée à la carte de circuits imprimés (1) ; ou
la seconde plaque de base est collée à la carte de circuits imprimés (1).
